# EUROPEAN PATENT SPECIFICATION

(11) **EP 1 115 273 B1**
(45) Date of publication and mention of the grant of the patent: **25.04.2007**
(21) Application number: 00128429.8
(22) Date of filing: 28.12.2000
(51) Int. Cl.: H05K 7/18

(54) **Frame assembly for boxes**
Rahmengestell für Kasten
Bâti pour boîtiers

(30) Priority: 05.01.2000 IT MI200004
(43) Date of publication of application: 11.07.2001
(73) Proprietor: COST.E.L. S.p.A., 28043 Bellinzago (No) (IT)
(72) Inventor: Bovi, Gianluigi, 28043 Bellinzago Novarese (NO) (IT); Bovio, Maurizio, 28043 Bellinzago Novarese (NO) (IT); Stocco, Gianpaolo, 28043 Bellinzago Novarese (NO) (IT); Miglio, Maurizio, 28043 Bellinzago Novarese (NO) (IT)
(74) Representative: Valentini, Giuliano

(56) References cited:
- DE-A- 4 135 108
- DE-C- 19 507 438
- DE-U- 8 335 383
- DE-U- 9 116 634
- DE-U- 29 820 610

## Description

This invention is related to a frame assembly designed for manufacturing control boxes, cabinets and the like.

The frame assembly in accordance with this invention is particularly suitable, but not only, for manufacturing control boxes destined to accept electrical panels and devices in general.

An example of frame assembly already known in the art is disclosed in DE 8335383. This document discloses a frame consisting of several section-bars, all having the same shape, obtained by bending a flat metal sheet.

The quadrangular section includes two mutually perpendicular sides that are concurrent to a common edge. Each side is fitted with rows of holes that are symmetrically located as regards to the edge and are longitudinally aligned along the length of the section-bar. An internal square-shape enclosure assures the required characteristics of torsion and bending strength and allows to accept, at the ends of each section-bar, the connecting elements for the corners of the frame.

The mutual connection of the section-bars at the corners is performed by a connecting element which is equipped with three arms that are mutually perpendicular and are inserted for a given length in the enclosure of the section-bars. In this case, the length of the arms causes in the section-bars the blinding of some holes that are provided for attachment of support or devices to the frame. For this reason, each arm is equipped with a series of threaded holes that are aligned with the related holes in the section-bars.

One of the main disadvantages of the frame disclosed in **DE 8335383** is the difficult to mount the devices to a frame manufactured with such section-bars. In fact, the devices are mounted using screws or bolts engaged in internal threads or nuts inserted into the section-bar enclosure. This requires the use of special nuts, and furthermore it is very difficult to put the nuts into the enclosure and hold them during the tightening operation.

In addition, the achievement of the correct alignment between the holes in the section-bars and the threaded holes in the arms of every connecting element requires close tolerances during manufacturing. Any misalignment could prevent the use of attachment holes that are located close to the corners of the frame, thus compromising the level of the quality of the mass-production.

Another disadvantage, due to the type of section-bar used to made the frame, is the difficult painting of the internal enclosure. The unpainted areas can easily oxidize or corrode with subsequent deterioration.

The object of this invention is to provide a frame assembly that simplifies the installation of the devices in control boxes or cabinets manufactured with this type of frame.

Another object of this invention is to provide a frame assembly that is very easy to assemble, both with manual or automatic operations.

Another object of this invention is to provide a frame assembly that allows to almost eliminating any deterioration caused by the oxidation.

A further object of this invention is to provide a section-bar having high torsion and bending strength characteristics.

These objects are achieved by the present invention, that is related to a frame assembly according to claim 1.

The dimensions of the access openings are adequate to make easier the access to the space included between the two perpendicular sides and allow to put a nut in that space and to hold it in position during the installation of the devices to the adjacent perpendicular side. The large access openings further allow to use the commercially available nuts, both in case of manual and automatic assembly.

The presence of the large access openings on one of the two sides makes also easier the painting of the areas included between the two perpendicular sides of the section-bars or, in any case, of a frame manufactured using these section-bars.

In accordance with an advantageous aspect of the invention, the opposite lateral edges of the metal sheet that forms the section-bar are joined together in such a way to form at least a first substantially square enclosure, accessible through the above mentioned access openings. The result is a closed-shape section-bar, thus a section-bar that has a great strength to torsion and bending stresses.

The section-bar of the frame assembly in accordance with this invention includes preferably also a pair of supplementary internal enclosures having substantially rectangular section. These supplementary enclosures form an extension of the square enclosure along the mutually perpendicular sides.

Each of the supplementary enclosures includes one of the smaller sides of the rectangular section that is able to receive in abutment a possible sealing element, for example an elastomeric gasket or the like. The seating of any gasket is particularly effective and safe along the minor sides, thus assuring an high degree of tightness to a cabinet manufactured using the frame assembly according to the invention.

The internal side of the metal sheet that forms the section-bar is preferably zinc-plated, in order to assure a high resistance to corrosion also in zones where the painting is insufficient or absent.

The fixation of the section-bars at the vertices of the parallelepiped structure is performed, for example, by welding the adjacent edges of the mutually perpendicular sides of the section-bars. Before welding, the section-bars that meet at the vertices of the frame are kept in position by suitable connecting means, each including a main body and at least three perpendicular arms.

The arms of each connecting means have shape and dimensions adequate to assure their insertion into the enclosures of the section-bars with interference coupling. To make easier the insertion in the section-bars, however, the arms are fitted with relief ribs on their external surfaces.

Further advantages and features of this invention will be evident from the following description, made for illustrative but not limiting purpose, with reference to the attached drawings, in which:
- Figure 1 is a section view of the section-bar of a frame assembly in accordance with this invention;
- Figure 2 is a perspective view of the section-bar of a frame assembly in accordance with this invention;
- Figure 3 is a perspective view of an unassembled part of a frame assembly in accordance with this invention;
- Figure 4 is a side view of a connecting element for a frame assembly in accordance with this invention;
- Figure 5 is a side elevation view, from the side opposite to that of Figure 4, of the connecting element.;
- Figure 6 is a bottom view with respect to the view of Figure 5, that shows a connecting element in accordance with this invention;
- Figure 7 is a section view, on the plane VII-VII of Figure 4, of the connecting element; and
- Figure 8 is a section view, on the plane VIII-VIII of Figure 4, of the connecting element.

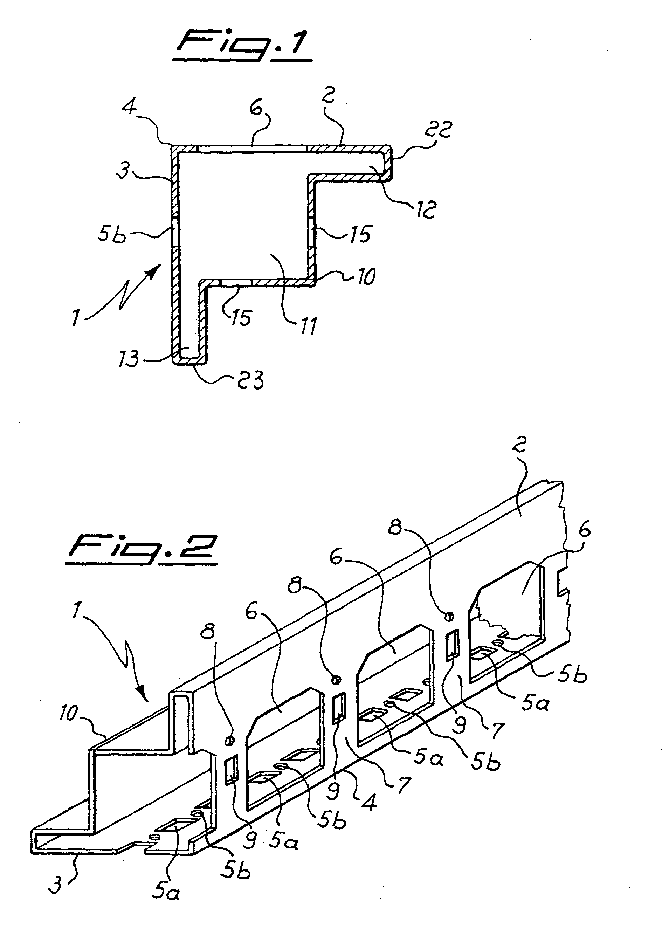

With reference firstly to Figures 1 and 2, the section-bar 1 that is used to manufacture the frame assembly in accordance with the invention, consists of a metal sheet that is bent to made a section that includes at least two mutually perpendicular sides 2 and 3, connected one to the other along a common edge 4.

The opposite edges of the metal sheet that forms the section-bar 1 are joined together, for example by welding, in correspondence of a junction line 10 in order to obtain at least a first internal enclosure 11 that has a substantially square shape.

The side 3 is provided with holes 5a and 5b, that are aligned on the longitudinal direction of the section-bar and allow to attach shelves, devices or similar equipment to the frame assembly in accordance with the invention. As well known and used in the art, the holes 5a have rectangular shape and have the pitch in accordance with the commonly used standard in the field of cabinets for control panels. The holes 5b have circular shape and also have a standard pitch. Further holes 15 (Figure 1) can be obtained in the section-bar 1 in correspondence of the internal sides of the enclosure 11.

The side 2 of the longitudinal dimension of the section-bar 1 is advantageously provided with openings 6. The openings 6 have dimensions larger than the holes 5a and 5b in order to get a better access to the internal space of the section-bar 1, in particular to the enclosure 11. For example, a section-bar with the sides 2 and 3 having 50-millimeter size, can be provided with openings 6 having 25-millimeter width and 80-millimeter length approximately. Each opening 6 is spaced from an adjacent opening by a 20-millimeter width band 7. The band 7, in addition, is provided with the holes 8 and 9 that are similar respectively to the holes 5b and 5a and are suitable for attachment of elements by means of screws or equivalent fasteners.

The openings 6 make easier the positioning and the tightening of a nut on the related screw inserted in anyone of the holes 5a and 5b that are located on the side 3 of the section-bar 1. The openings 6 assure a better painting of the internal zone enclosed in the section-bar 1. In any case, in order to avoid the possibility of oxidation buildup, the internal surface of the metal sheet that forms the section-bar 1 is zinc-plated.

With reference to Figure 1, it can be noted that the section-bar 1 is further provided with a pair of supplementary internal enclosures 12 and 13, that form an extension of the internal enclosure 11 along the edges 2 and 3 of the section-bar 1. The supplementary enclosures 12 and 13 include advantageously the small sides at the ends of the rectangular section, indicated respectively with 22 and 23 which assure an adequate abutment surface for sealing elements, for example gaskets or the like, that are normally applied on the walls and/or doors of the cabinet manufactured with the frame assembly made of the section-bars 1.

Figure 3 shows a schematic example of a portion of the frame assembly in accordance with the invention, where the parts of the section-bars 1a, 1b and 1c are arranged with the edge 4 oriented towards the internal space defined by the frame assembly.

The three section-bars 1a, 1b and 1c are connected to the vertex of the frame assembly by means of a connecting element 20, that is equipped with three perpendicular arms 20a, 20b and 20c having shape and dimensions suitable for insertion in the openings of the related section-bars.

The arms 20a, 20b and 20c of the connecting element 20, are inserted with interference in the enclosures of the related section-bars 1a, 1b and 1c in such a way to allow the welding of the section-bars along the mutually coupled edges. It is thus made more easier and faster to hold the section-bars in position during the welding. It should be noted that welding is performed on straight sections of material of the same thickness. The insertion of the section-bars on the connecting elements and the subsequent welding of the adjacent edges of the section-bars can be therefore performed with automatic cycle.

For simplicity, only the connection at one vertex of the parallelepiped structure has been shown, for example the lower left corner of the front face of the frame, but it is evident that the connection at the remaining vertices of the parallelepiped structure is performed in the same manner using the same connecting elements 20.

Figures 4-8 show some detailed views of a connecting element 20 suitable for use in a frame assembly in accordance with this invention. The connecting element 20 is made of metallic material, for example zinc or aluminum alloy, and can be made by pressure die-casting or other processes that allow to obtain an item having the characteristics as described below.

The connecting element 20 includes a main body 30, from which the arms 20a, 20b and 20c protrude, the latter being shaped so they can be inserted at least in the first enclosure 11 of the related section-bars or more preferably, also in the supplementary enclosures 12 and 13 of the section-bars

For example, arm 20a, visible in Figures 4 and 5, includes a portion 121 a, whose section is substantially square, that is inserted in the first enclosure 11 of the related section-bar 1a, as well as two perpendicular fins 122a and 123a that are inserted in the enclosures 12 and 13 of the related section-bar 1a. Fins 122a and 123a are therefore an extension of two concurrent sides of the portion 121a, which has a square section, as well as the supplementary enclosures 12 and 13 are similarly the extensions of the first internal enclosure 11. In the same manner, the arm 20b, visible in plan in the view of Figure 5, includes a portion 121b that has a substantially square section and a pair of fins 122b and 123b, and the arm 20c includes a portion of substantially square section 121 c and a pair of fins 122c and 123c.

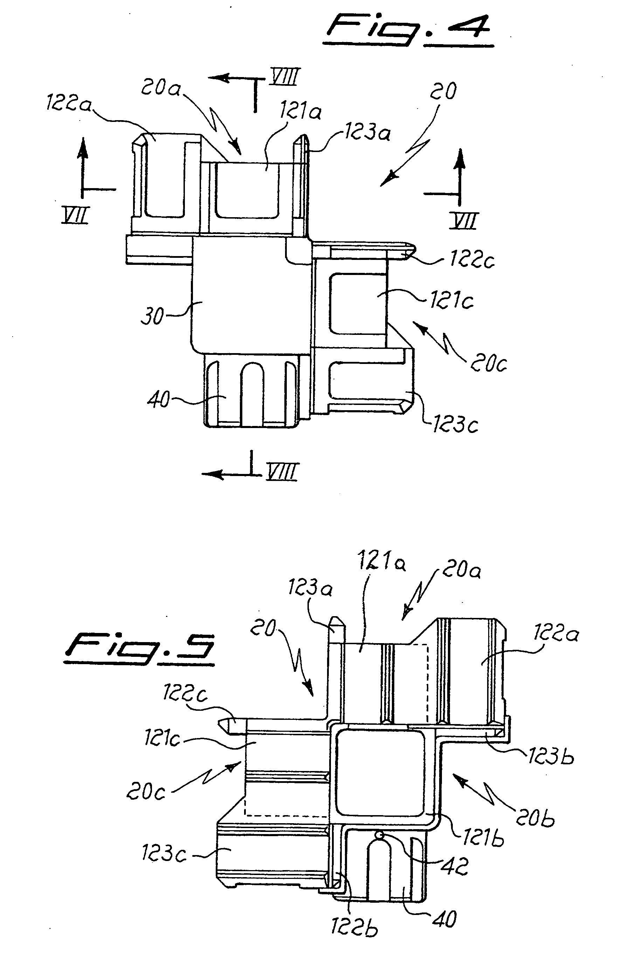

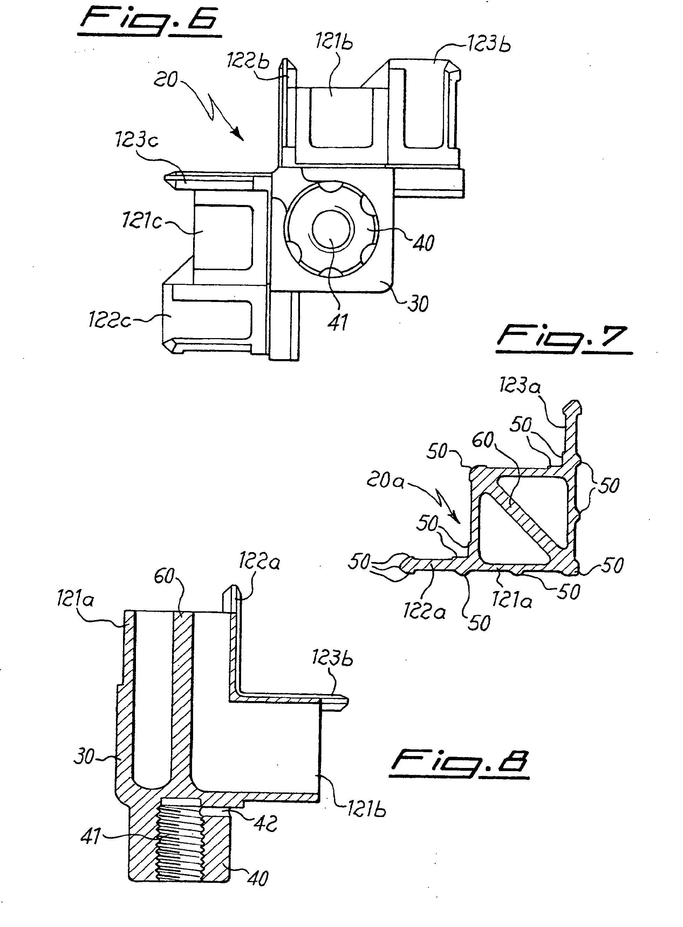

On the opposite side of the arm 20a, it is located a supporting portion 40 protruding from the body 30 and equipped on its interior with a threaded hole 41 (Figures 6 and 8). The hole 41 allows to screw-in several hanging means, such as hooks, rings and the like, to the upper part of the frame assembly. These hanging means are useful to handle the frame, and/or the cabinet manufactured with the frame, during assembly and finishing operations, as well as during installation on the final site. In the lower side, the holes 41 in the supporting portion 40 can accept the threaded rods of supporting feet.

As shown in Figures 5 and 8, it is preferable to provide a through-hole 42, that puts the threaded hole 41 in communication with the exterior. This little hole 42 allows to drain any fluid used during the manufacture, for example washing, degreasing or similar fluids, from the connecting elements 20 in the upper part of the frame, if no any hanging means is screwed-in on the above elements during the treatments.

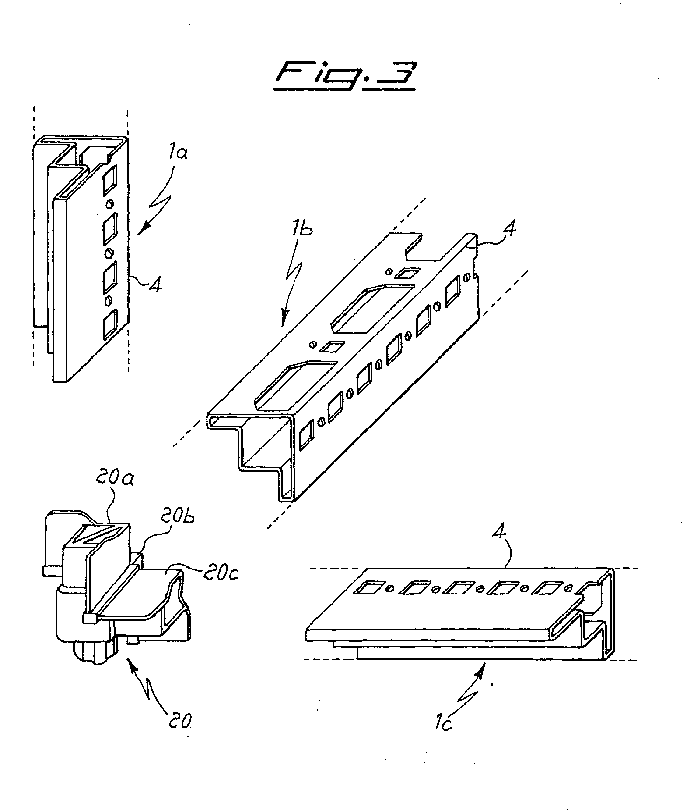

The view of Figure 7 shows the portion of one of the arms, in particular the arm 20a, in a section view that highlights the already described shape of this arm,. In accordance with a peculiar feature of this invention, some relief ribs 50 are provided on the external surfaces of the portion 121 a and fins 122a and 123a that allow a better insertion of arm 20a in the related enclosures of the section-bar. The insertion of the section-bars on the arms of each connecting element 20 can be therefore performed very quickly and without excessive effort, also if burrs are present on the mating parts.

As shown in the section views of Figures 7 and 8, the connecting element 20 has an internally void section, both in the body 30 and in the portions 121a, 121b and 121c of the arms 20a, 20b and 20c. A stiffening wall 60, located diagonally on the square cavity of the body 30 and of the part 121a, is preferably arranged along the direction of the compression an traction forces applied to the frame, in order to increase the strength of the frame assembly or of the cabinet manufactured with the same.

## Claims

1. A frame assembly for control boxes, cabinets or the like, of the type comprising a plurality of section-bars (1, 1a, 1b, 1c) having the same section and perpendicularly connected together to form a parallelepiped structure, wherein said section-bars (1, 1a, 1b, 1c) are arranged substantially aligned to the edges of said structure, each of said section-bars (1, 1a, 1b, 1c) comprising a bent metal sheet having a section with at least two sides (2, 3) that are mutually perpendicular and are connected one to the other along a common edge (4), at least a first one (3) of said at least two perpendicular sides (2, 3) of each of said section-bars (1, 1a, 1b, 1c) being provided, on its entire length, with a series of holes (5a, 5b) aligned along the longitudinal direction of the section-bar; and connecting means (20) between said section-bars (1, 1a, 1b, 1c) in correspondence of the vertices of said parallelepiped structure, **characterised in that** the second one (2) of said at least two perpendicular sides (2, 3) of each of said section-bars (1, 1a, 1b, 1c) is provided with a series of access openings (6) aligned along the longitudinal direction of the section-bar, each of said access openings (6) having its longitudinal dimension larger than its transversal dimension, and at least said longitudinal dimension being larger than the sum of the maximum dimension of at least two of said holes (5a, 5b).

2. A frame assembly according to claim 1, wherein the opposite lateral edges of the metal sheet forming each of the section-bars (1, 1a, 1b, 1c) are joined together to form at least a first internal enclosure (11) that is accessible through said access openings (6).

3. A frame assembly according to claim 2, wherein said first internal enclosure (11) in each of said section-bars (1, 1a, 1b, 1c) has a substantially square shape.

4. A frame assembly according to claim 1 or 2, wherein each of said section-bars (1, 1a, 1b, 1c) further comprises at least a pair of supplementary internal enclosures (12, 13) having substantially rectangular shape, said supplementary internal enclosures (12, 13) being extensions of said first enclosure (11) along the mutually perpendicular edges.

5. A frame assembly according to claim 4, wherein each of said supplementary internal enclosures (12, 13) comprises at the end a smaller side (22, 23) of the rectangular section in order to receive in abutment at least a sealing element.

6. A frame assembly according to claim 1, wherein the lateral opposite edges of the metal sheet forming each of the section-bars (1, 1a, 1b, 1c) are joined together by welding.

7. A frame assembly according to claim 1, wherein each of said access openings (6) in each section-bar (1, 1a, 1b, 1c) is separated from any adjacent access opening by a strip of said metal sheet.

8. A frame assembly according to claim 1, wherein at least the internal surface of said metal sheet that forms each of said section-bars (1, 1a, 1b, 1c) is zinc-plated.

9. A frame assembly according to claim 1, wherein said section-bars (1, 1a, 1b, 1c) are attached together in correspondence of the vertices of said parallelepiped structure by welding of the adjacent edges of said mutually perpendicular sides (2, 3) of said section-bars (1, 1a, 1b, 1c).

10. A frame assembly according to claim 1, wherein said section-bars (1, 1a, 1b, 1c) are connected together with said common edge (4) that is oriented toward the interior of the frame assembly.

11. A frame assembly according to any of claims 1 to 5, wherein each of said connecting means (20) includes at least a main body and at least three arms (20a, 20b, 20c) that are respectively perpendicular.

12. A frame assembly according to claim 11, wherein each of said arms (20a, 20b, 20c) has shape and dimensions that allow its insertion into at least said first internal enclosure (11).

13. A frame assembly according to claim 11, wherein each of said arms (20a, 20b, 20c) has shape and dimensions that allow its insertion into said first internal enclosure (11) and into said supplementary internal enclosures (12, 13).

14. A frame assembly according to claim 12 or 13, wherein said arms (20a, 20b, 20c) include relief ribs (50) on their external surfaces that make easier the insertion into said enclosures (11, 12, 13) of said section-bars(1, 1a, 1b, 1c).

15. A frame assembly according to claim 14, wherein said arms (20a, 20b, 20c) are coupled with interference to said section-bars (1, 1a, 1b, 1c).

16. A frame assembly according to claim 11, wherein said body (30) includes an internal hollow section.

17. A frame assembly according to claim 11, wherein one or more of said three arms (20a, 20b, 20c) include an internal hollow section.

18. A frame assembly according to claim 16 or 17, wherein reinforcing means (60) are provided within at least one of said hollow sections.

## Patentansprüche

1. Rahmengestell für Steuerkästen, -schränke oder dergleichen, des Typs umfassend mehrere Profilleisten (1, 1a, 1b, 1c), die das gleiche Profil aufweisen und senkrecht miteinander verbunden sind, um eine Parallelepiped-Struktur zu bilden, wobei die Profilleisten (1, 1a, 1b, 1c) so angeordnet sind, dass sie im Wesentlichen entlang der Kanten dieser Struktur ausgerichtet sind, wobei jede Profilleiste (1, 1a, 1b, 1c) ein gebogenes Metallblech umfasst, das ein Profil mit wenigstens zwei Seiten (2, 3) aufweist, die zueinander senkrecht sind und entlang einer gemeinsamen Kante (4) miteinander verbunden sind, wobei wenigstens eine erste (3) dieser wenigstens zwei senkrecht stehenden Seiten (2, 3) einer jeden Profilleiste (1, 1a, 1b, 1c) auf ihrer gesamten Länge mit einer Reihe von Löchern (5a, 5b) versehen ist, die entlang der Längsrichtung der Profilleiste ausgerichtet sind; und Hilfsmittel zum Verbinden (20) zwischen den Profilleisten (1, 1a, 1b, 1 c) entsprechend den Ecken der Parallelepiped-Struktur, **dadurch gekennzeichnet, dass** die zweite (2) dieser wenigstens zwei senkrechten Seiten (2, 3) jeder Profilleiste (1, 1a, 1b, 1c) mit einer Reihe von Zugangsöffnungen (6) versehen ist, die entlang der Längsrichtung der Profilleiste ausgerichtet sind, wobei jede Zugangsöffnung (6) eine Längenausdehnung aufweist, die größer ist als deren Querausdehnung, und wobei wenigstens die Längenausdehnung größer ist als die Summe der Maximalausdehnung von wenigstens zwei dieser Löcher (5a, 5b).

2. Rahmengestell nach Anspruch 1, wobei die gegenüberliegenden seitlichen Ränder des Metallblechs, aus dem jede Profilleiste (1, 1a, 1b, 1c) gebildet ist, miteinander verbunden sind, um wenigstens eine erste innere Einfassung (11) zu bilden, die über die Zugangsöffnungen (6) zugänglich ist.

3. Rahmengestell nach Anspruch 2, wobei die erste innere Einfassung (11) in jeder der Profilleisten (1, 1a, 1b, 1c) eine im Wesentlichen quadratische Form aufweist.

4. Rahmengestell nach Anspruch 1 oder 2, wobei jede der Profilleisten (1, 1a, 1b, 1c) des Weiteren wenigstens ein Paar zusätzliche innere Einfassungen (12, 13) umfasst, die im Wesentlichen eine rechteckige Form aufweisen, wobei die zusätzlichen inneren Einfassungen (12, 13) Verlängerungen der ersten inneren Einfassung (11) entlang der zueinander senkrechten Ränder darstellen.

5. Rahmengestell nach Anspruch 4, wobei jede zusätzliche innere Einfassung (12, 13) am Ende eine kürzere Seite (22, 23) des rechteckigen Profils umfasst, um wenigstens ein Dichtungselement anliegend aufzunehmen.

6. Rahmengestell nach Anspruch 1, wobei die seitlichen gegenüberliegenden Ränder des Metallblechs, aus dem jede der Profilleisten (1, 1a, 1b, 1c) gebildet ist, durch Verschweißen miteinander verbunden sind.

7. Rahmengestell nach Anspruch 1, wobei jede der Zugangsöffnungen (6) in jeder Profilleiste (1, 1a, 1b, 1c) von der jeweils benachbarten Zugangsöffnung durch einen Streifen des Metallblechs abgetrennt ist.

8. Rahmengestell nach Anspruch 1, wobei wenigstens die Innenfläche des Metallblechs, aus dem jede der Profilleisten (1, 1a, 1b, 1c) gebildet ist, verzinkt ist.

9. Rahmengestell nach Anspruch 1, wobei die Profilleisten (1, 1a, 1b, 1c) entsprechend den Ecken der Parallelepiped-Struktur durch Verschweißen der benachbarten Ränder der zueinander senkrechten Seiten (2, 3) der Profilleisten (1, 1a, 1b, 1c) miteinander verbunden sind.

10. Rahmengestell nach Anspruch 1, wobei die Profilleisten (1, 1a, 1b, 1c) über die gemeinsame Kante (4) miteinander verbunden sind, die in Richtung des Inneren des Rahmengestells ausgerichtet ist.

11. Rahmengestell nach einem der Ansprüche 1 bis 5, wobei jedes Hilfsmittel zum Verbinden (20) wenigstens einen Hauptkörper und wenigstens drei Arme (20a, 20b, 20c) umfasst, die jeweils senkrecht zueinander sind.

12. Rahmengestell nach Anspruch 11, wobei jeder der Arme (20a, 20b, 20c) eine Form und Abmessungen aufweist, die dessen Einführung in wenigstens die erste innere Einfassung (11) ermöglichen.

13. Rahmengestell nach Anspruch 11, wobei jeder der Arme (20a, 20b, 20c) eine Form und Abmessungen aufweist, die dessen Einführung in die erste innere Einfassung (11) und in die zusätzlichen inneren Einfassungen (12, 13) ermöglichen.

14. Rahmengestell nach Anspruch 12 oder 13, wobei die Arme (20a, 20b, 20c) Entlastungsrippen (50) auf deren Außenflächen umfassen, die die Einführung in die Einfassungen (11, 12, 13) der Profilleisten (1, 1a, 1b, 1c) erleichtern.

15. Rahmengestell nach Anspruch 14, wobei die Arme (20a, 20b, 20c) in Unterschneidung an die Profilleisten (1, 1a, 1b, 1c) angesetzt sind.

16. Rahmengestell nach Anspruch 11, wobei der Körper (30) ein inneres Hohlprofil umfasst.

17. Rahmengestell nach Anspruch 11, wobei ein oder mehrere der drei Arme (20a, 20b, 20c) ein inneres Hohlprofil umfassen.

18. Rahmengestell nach Anspruch 16 oder 17, wobei Hilfsmittel zur Verstärkung (60) in wenigstens einem der Hohlprofile bereitgestellt sind.

## Revendications

1. Bâti destiné à des boîtes de commande, armoires ou similaires, du type comprenant plusieurs barres de profilé (1, 1a, 1b, 1c) ayant la même section et reliées perpendiculairement les unes avec les autres pour former une structure parallélépipédique, dans lequel lesdites barres de profilé (1, 1a, 1b, 1c) sont arrangées de façon substantiellement alignée sur les bords de ladite structure, chacune desdites barres de profilé (1, 1a, 1b, 1c) comprenant une feuille de métal pliée présentant une section avec au moins deux côtés (2, 3) qui sont mutuellement perpendiculaires et qui sont connectés l'un à l'autre le long d'un bord commun (4), au moins un premier (3) des deux côtés perpendiculaires (2, 3) de chacune desdites barres de profilé (1, 1a, 1b, 1c) étant muni, sur toute sa longueur, d'une série de trous (5a, 5b) alignés le long de la direction longitudinale de la barre de profilé ; et un moyen de connexion (20) entre lesdites barres de profilé (1, 1a, 1b, 1c) en correspondance avec les points de concours des arêtes de ladite structure parallélépipédique, **caractérisé en ce que** le deuxième (2) desdits au moins deux côtés perpendiculaires (2, 3) de chacune desdites barres de profilé (1, 1a, 1b, 1c) est muni d'une série d'ouvertures d'accès (6) alignées le long de la direction longitudinale de la barre de profilé, chacune desdites ouvertures d'accès (6) ayant sa dimension longitudinale plus longue que sa dimension transversale, et au moins ladite dimension longitudinale étant plus grande que la somme des dimensions maximales d'au moins deux desdits trous (5a, 5b).

2. Bâti selon la revendication 1, dans lequel les côtés latéraux opposés de la feuille de métal formant chacune des barres de profilé (1, 1a, 1b, 1c) sont joints ensemble pour former au moins une première enceinte intérieure (11) qui est accessible par lesdites ouvertures d'accès (6).

3. Bâti selon la revendication 2, dans lequel ladite première enceinte intérieure (11) dans chacune desdites barres de profilé (1, 1a, 1b, 1c) présente une forme sensiblement carrée.

4. Bâti selon la revendication 1 ou 2, dans lequel chacune desdites barres de profilé (1, 1a, 1b, 1c) comprend en outre au moins une paire d'enceintes intérieures supplémentaires (12, 13) présentant une forme sensiblement rectangulaire, lesdites enceintes intérieures supplémentaires (12, 13) étant des prolongements de ladite première enceinte (11) le long des bords mutuellement perpendiculaires.

5. Bâti selon la revendication 4, dans lequel chacune desdites enceintes intérieures supplémentaires (12, 13) comporte à l'extrémité un côté plus petit (22, 23) de la partie rectangulaire de façon à recevoir en butée au moins un élément de fixation.

6. Bâti selon la revendication 1, dans lequel les bords opposés latéraux de la feuille de métal formant chacune des barres de profilé (1, 1a, 1b, 1c) sont joints ensemble par soudure.

7. Bâti selon la revendication 1, dans lequel chacune desdites ouvertures d'accès (6) dans chaque barre de profilé (1, 1a, 1b, 1c) est séparée de toute ouverture d'accès adjacente par une bande de ladite feuille de métal.

8. Bâti selon la revendication 1, dans lequel au moins la surface intérieure de ladite feuille de métal qui forme chacune desdites barres de profilé (1, 1a, 1b, 1c) est zinguée.

9. Bâti selon la revendication 1, dans lequel lesdites barres de profilé (1, 1a, 1b, 1c) sont attachées les unes aux autres de façon correspondante aux points de concours des arêtes de ladite structure parallélépipédique par soudure des bords adjacents desdits côtés mutuellement perpendiculaires (2, 3) desdites barres de profilé (1, 1a, 1b, 1c).

10. Bâti selon la revendication 1, dans lequel lesdites barres de profilé (1, 1a, 1b, 1c) sont reliées les unes avec les autres avec ledit bord commun (4) qui est orienté en direction de l'intérieur du bâti.

11. Bâti selon l'une quelconque des revendications 1 à 5, dans lequel chacun des moyens de connexion (20) comprend au moins un corps principal et au moins trois bras (20a, 20b, 20c) qui sont respectivement perpendiculaires.

12. Bâti selon la revendication 11, dans lequel chacun desdits bras (20a, 20b, 20c) présente une forme et des dimensions qui permettent son insertion à l'intérieur d'au moins ladite première enceinte intérieure (11).

13. Bâti selon la revendication 11, dans lequel chacun desdits bras (20a, 20b, 20c) présente une forme et les dimensions qui permettent son insertion à l'intérieur de ladite première enceinte intérieure (11) et à l'intérieur desdites enceintes intérieures supplémentaires (12, 13).

14. Bâti selon la revendication 12 ou 13, dans lequel lesdits bras (20a, 20b, 20c) comprennent des nervures en relief (50) sur leurs surfaces extérieures qui rendent plus facile leur insertion à l'intérieur desdites enceintes (11, 12, 13) desdites barres de profilé (1, 1a, 1b, 1c)

15. Bâti selon la revendication 14, dans lequel lesdits bras (20a, 20b, 20c) sont réunis par serrage à force aux dites barres de profilé (1, 1a, 1b, 1c).

16. Bâti selon la revendication 11, dans lequel ledit corps (30) comprend une partie intérieure creuse.

17. Bâti selon la revendication 11, dans lequel un ou plus desdits trois bras (20a, 20b, 20c) comprend une partie intérieure creuse.

18. Bâti selon la revendication 16 ou 17, dans lequel un moyen de renfort (60) est disposé à l'intérieur d'au moins une desdites parties intérieures creuses.
